# EUROPEAN PATENT SPECIFICATION

(11) **EP 3 064 537 B1**
(45) Date of publication and mention of the grant of the patent: **19.09.2018**
(21) Application number: 14858503.7
(22) Date of filing: 08.10.2014
(51) Int. Cl.: H01L 41/193, H01G 4/14, C08J 7/06, H01L 41/45

(54) **FILM AND METHOD FOR PRODUCING SAME**
FOLIE UND VERFAHREN ZUR HERSTELLUNG DAVON
FILM ET SON PROCÉDÉ DE PRODUCTION

(30) Priority: 29.10.2013 JP 2013224710; 15.01.2014 JP 2014005290
(43) Date of publication of application: 07.09.2016
(73) Proprietor: Daikin Industries, Ltd., Osaka-shi, Osaka 530-8323 (JP)
(72) Inventor: KOU, Meiten, Osaka 5308323 (JP); KANEMURA, Takashi, Osaka 5308323 (JP); MUKAI, Eri, Osaka 5308323 (JP); KODANI, Tetsuhiro, Osaka 5308323 (JP)
(74) Representative: Hoffmann Eitle
(86) International application number: PCT/JP2014/077009
(87) International publication number: WO 2015/064325

(56) References cited:
- WO-A1-2013/057987
- JP-A- 2004 307 830
- JP-A- 2007 042 581
- JP-A- 2009 272 924
- US-A1- 2010 067 172
- US-A1- 2010 246 094
- US-A1- 2011 228 442
- SHIHAI ZHANG ET AL: "Semicrystalline polymers with high dielectric constant, melting temperature, and charge-discharge efficiency", IEEE TRANSACTIONS ON DIELECTRICS AND ELECTRICAL INSULATION, IEEE SERVICE CENTER, PISCATAWAY, NJ, US, vol. 19, no. 4, 1 August 2012 (2012-08-01) , pages 1158-1166, XP011455722, ISSN: 1070-9878, DOI: 10.1109/TDEI.2012.6259984

## Description

### Technical Field

The present invention relates to a film and a method for producing the same.

### Background Art

Various organic dielectric films and inorganic dielectric membranes have been known as films and membranes used for piezoelectric films, electrowetting applications, and film capacitor applications.

Of these, polarized vinylidene fluoride-based polymer films can be used for a variety of applications because they are advantageous in that they are transparent and, unlike inorganic dielectric thin membranes, are flexible.

For example, Patent Literature 1 and Patent Literature 2 disclose a technique in which the function of detecting touch pressure is imparted to a touch panel using a polarized vinylidene fluoride-based polymer film.

Patent Literature 3 discloses a high electric energy density polymer film capacitors with high charge-discharge efficiency and fast discharge speed. For example, a high energy density polymer capacitor may be fabricated using a polymer blend comprising one or more high dielectric constant PVDF-based polymers (poly-vinylidene fluoride).

### Citation List

### Patent Literature

PTL 1: JP2010-026938A
PTL 2: JP2011-222679A
PTL 3: US2010/0067172

### Summary of Invention

### Technical Problem

As a method for producing a polarized vinylidene fluoride-based polymer film, Patent Literature 1 discloses a method in which a solution of a vinylidene fluoride-based polymer dissolved in an organic solvent is applied to a separately prepared substrate, and the solvent is removed to form a membrane (so-called casting method). However, in Patent Literature 1, sufficient investigation is not carried out on filtration of the solution.

The present inventors conducted research on the production method above and found that when the solution is not filtered, the film has low electrical insulation properties, resulting in a reduction in the withstand voltage properties of the film. The inventors also found that when the solution is filtered with a yarn-wound filter, a surface filter, a roll type filter, or the like, the filtration cannot be efficiently performed.

Therefore, an object of the present invention is to provide a film exhibiting high electrical insulation properties and excellent withstand voltage properties, and a method for producing the film.

### Solution to Problem

The present inventors conducted extensive research and found that the above object can be achieved by a vinylidene fluoride-based polymer film in which the 99% voltage failure resistance value in a Weibull plot is 300 V/µm or more.

Further, the present inventors found that when a liquid composition containing a vinylidene fluoride-based polymer and a solvent is filtered with a depth-pleated type filter, a film having the above properties can be produced.

Based on these findings, the present inventors have accomplished the present invention.

The present invention includes the following embodiments.

Item 1. A vinylidene VdF/TFE copolymer film in which the 99% voltage failure resistance value in a Weibull plot is 300 V/µm or more.
Item 2. The film according to Item 1, wherein the copolymer film is a piezoelectric film.
Item 3. The film according to Item 1, wherein the copolymer film is a film for a film capacitor.
Item 4. A method for producing the film according to any one of Items 1 to 3, the method comprising:
   step A of preparing a liquid composition containing a vinylidene fluoride-based polymer and a solvent;
   step B of filtering the liquid composition using a depth-pleated type filter;
   step C of casting the filtrate obtained in step B onto a substrate; and
   step D of evaporating the solvent from the cast filtrate to form a VdF/TFE copolymer film.
Item 5. A method for producing the film according to Item 1 or 2, the method comprising:
   step A of preparing a liquid composition containing a vinylidene fluoride-based polymer and a solvent;
   step B of filtering the liquid composition using a depth-pleated type filter;
   step C of casting the filtrate obtained in step B onto a substrate;
   step D of evaporating the solvent from the cast filtrate to form a non-polarized VdF/TFE copolymer film;
   step E of subjecting the film to polarization treatment to obtain a polarized VdF/TFE copolymer film; and
   step F of heat-treating the non-polarized or polarized VdF/TFE copolymer film.

### Advantageous Effects of Invention

The film of the present invention exhibits high electrical insulation properties and excellent withstand voltage properties. Moreover, with the method for producing a film of the present invention, a film exhibiting high electrical insulation properties and excellent withstand voltage properties can be produced.

### Description of Embodiments

### Meaning of terms

As used herein, "detection" of a "touch position" means determination of a touch position, and "detection" of "touch pressure" means determination of the presence or absence, speed, or degree (intensity) of pressing, or changes thereof, or combinations thereof.

As used herein, the term "touch" encompasses touching, being touched, pressing, being pressed, and contacting.

As used herein, the term "polarized" means that electric charges are imparted to the surface. More specifically, the polarized film can be an electret.

### Film

The film of the present invention is a Vdf/TFE copolymer film in which the 99% voltage failure resistance value in a Weibull plot is 300 V/µm or more. Thus, the film of the present invention exhibits high electrical insulation properties and excellent withstand voltage properties.

As used herein, the phrase "the 99% voltage failure resistance value in a Weibull plot is 300 V/µm or more" means that when the withstand voltage until short-circuiting is plotted in the Weibull distribution, the value at which the probability of failure is 1% is 300 V/µm or more. The withstand voltage is measured by applying voltage to a film while increasing the voltage at a speed of 100 V per minute.

In the case where the 99% voltage failure resistance value of a VdF/TFE copolymer film in a Weibull plot is less than 300 V/µm, the withstand voltage is low. Thus, when a film in which the voltage failure resistance value is less than 300 V/µm is used for piezoelectric materials, short-circuiting occurs in the step of subjecting the film to polarization treatment, and the short circuit portions are burnt black, deteriorating the color tone. When a film in which the voltage failure resistance value is less than 300 V/µm is used for film capacitors or the like to which voltage is applied, short-circuiting may occur before the prescribed voltage, resulting in a defective product.

The film of the present invention may comprise components other than the polymer or may comprise an inorganic substance.

The content of the copolymer in the film of the present invention is preferably 70 mass% or more, more preferably 75 mass% or more, even more preferably 80 mass% or more, and still more preferably 90 mass% or more. The upper limit of the content of the polymer is not particularly limited, and may be, for example, 100 mass% or 99 mass%.

The VdF/TFE copolymer may comprise additives generally used in resin films.

The is a film constituted from a vinylidene fluoride-based polymer, and contains a vinylidene fluoride-based polymer.

An example of a VdF/TFE copolymer is a copolymer of vinylidene fluoride and one or more monomers copolymerizable with vinylidene fluoride.

Examples of the "monomers copolymerizable with vinylidene fluoride" in the " copolymer of vinylidene fluoride and one or more monomers copolymerizable with vinylidene fluoride" include trifluoroethylene, tetrafluoroethylene, hexafluoropropylene, chlorotrifluoroethylene, and vinyl fluoride.

The "one or more monomers copolymerizable with vinylidene fluoride" are preferably, or at least one of them is preferably, tetrafluoroethylene.

Preferred examples of the "vinylidene fluoride-based polymer" include vinylidene fluoride/tetrafluoroethylene copolymers.

The "vinylidene fluoride/tetrafluoroethylene copolymer" may contain repeating units derived from a monomer other than vinylidene fluoride and tetrafluoroethylene, insofar as the characteristics regarding the present invention are not significantly impaired.

The "copolymer of vinylidene fluoride and one or more monomers copolymerizable with vinylidene fluoride" contains 50 mol% or more (preferably 60 mol% or more) of repeating units derived from vinylidene fluoride.

The molar ratio of (repeating units derived from tetrafluoroethylene)/(repeating units derived from vinylidene fluoride) in the "vinylidene fluoride/tetrafluoroethylene copolymer" is preferably within the range of 5/95 to 36/64, more preferably 15/85 to 25/75, and even more preferably 18/82 to 22/78.

The "vinylidene fluoride/tetrafluoroethylene copolymer" may contain repeating units derived from a monomer other than vinylidene fluoride and tetrafluoroethylene, insofar as the characteristics regarding the present invention are not significantly impaired. The content of such repeating units is generally 10 mol% or less. Such monomers are not limited as long as they can be copolymerized with a vinylidene fluoride monomer and a tetrafluoroethylene monomer. Examples thereof include:
(1) fluoromonomers (e.g., vinyl fluoride (VF), trifluoroethylene (TrFE), hexafluoropropene (HFP), 1-chloro-1-fluoro-ethylene (1,1-CFE), 1-chloro-2-fluoro-ethylene (1,2-CFE), 1-chloro-2,2-difluoroethylene (CDFE), chlorotrifluoroethylene (CTFE), trifluorovinyl monomers, 1,1,2-trifluorobutene-4-bromo-1-butene, 1,1,2-trifluorobutene-4-silane-1-butene, perfluoroalkyl vinyl ether, perfluoromethyl vinyl ether (PMVE), perfluoropropyl vinyl ether (PPVE), perfluoroacrylate, 2,2,2-trifluoroethyl acrylate, and 2-(perfluorohexyl)ethyl acrylate); and
(2) hydrocarbon based monomers (e.g., ethylene, propylene, maleic anhydride, vinyl ether, vinyl ester, allyl glycidyl ether, acrylic acid based monomers, methacrylic acid based monomers, and vinyl acetate).

The thickness of the film of the present invention is, for example, within the range of 0.5 to 100 µm, within the range of 0.8 to 50 µm, within the range of 0.8 to 40 µm, within the range of 3 to 100 µm, within the range of 3 to 50 µm, within the range of 6 to 50 µm, within the range of 9 to 40 µm, within the range of 10 to 40 µm, or within the range of 10 to 30 µm. The preferred thickness of the film may differ depending on the application of the film of the present invention. For example, when the film of the present invention is used for piezoelectric panels, such as touch panels, the thickness of the film of the present invention is preferably within the range of 10 to 40 µm, and more preferably 10 to 30 µm. When the film of the present invention is used for electrowetting devices, the thickness of the film of the present invention is preferably within the range of 0.5 to 5 µm, and more preferably 0.8 to 2 µm. When the film of the present invention is used for film capacitors, the thickness of the film of the present invention is preferably within the range of 1.5 to 12 µm.

Preferred examples of the "inorganic substance" include inorganic oxide particles. When the film of the present invention contains "inorganic oxide particles," it can exhibit a high dielectric constant. This also enables the volume resistivity to be significantly improved while maintaining a high dielectric constant.

The "inorganic oxide particles" are preferably at least one member selected from the group consisting of inorganic oxide particles (B1) to (B3) described below.

Inorganic oxide particles (B1) are particles of an inorganic oxide of a metallic element of Group 2, 3, 4, 12, or 13 in the periodic table, or inorganic oxide composite particles of these.

Examples of the metallic element include Be, Mg, Ca, Sr, Ba, Y, Ti, Zr, Zn, Al, and the like. Of these, oxides of Al, Mg, Y, and Zn are preferable since they are versatile and inexpensive and also since they have high volume resistivity.

More specifically, particles of at least one metal oxide selected from the group consisting of Al₂O₃, MgO, ZrO₂, Y₂O₃, BeO, and MgO·Al₂O₃ are particularly preferable in terms of high volume resistivity.

Of these, Al₂O₃ having a γ-type crystal structure is even more preferable because of its large specific surface area and good dispersibility in the vinylidene fluoride-based polymer.

Inorganic oxide particles (B2) are particles of an inorganic complex oxide represented by formula: M¹ₐ₁M²_{b1}O_{c1} wherein M¹ represents a metallic element of Group 2; M² represents a metallic element of Group 4; a1 represents 0.9 to 1.1; b1 represents 0.9 to 1.1; c1 represents 2.8 to 3.2; and M¹ and M² may each be a single metallic element or multiple metallic elements.

Preferred examples of the "metallic element of Group 4" include Ti and Zr.

Preferred examples of the "metallic element of Group 2" include Mg, Ca, Sr, and Ba.

More specifically, of the "particles of an inorganic complex oxide," particles of at least one inorganic oxide selected from the group consisting of BaTiO₃, SrTiO₃, CaTiO₃, MgTiO₃, BaZrO₃, SrZrO₃, CaZrO₃, and MgZrO₃ are preferable because they have high volume resistivity.

Inorganic oxide particles (B3) are inorganic oxide composite particles of an oxide of a metallic element of Group 2, 3, 4, 12, or 13 in the periodic table and silicon oxide.

The "inorganic oxide particles (B3)" are composite particles of the "inorganic oxide" in the "inorganic oxide particles (B1)" and silicon oxide.

More specifically, the "inorganic oxide particles (B3)" are, for example, particles of at least one inorganic oxide selected from the group consisting of 3Al₂O₃·2SiO₂, 2MgO·SiO₂, ZrO₂·SiO₂, and MgO·SiO₂.

The "inorganic oxide particles" are not necessarily highly dielectric and may be suitably selected according to the intended purpose of the film of the present invention. For example, the use of particles of a versatile and inexpensive metal oxide (B1) (in particular, particles of Al₂O₃ and particles of MgO) makes it possible to improve the volume resistivity. The relative dielectric constant (1 kHz, 25°C) of the particles of such a metal oxide (B1) is generally less than 100, and preferably 10 or less.

As the "inorganic oxide particles," inorganic oxide particles (e.g., inorganic oxide particles (B2) and (B3)) that are ferroelectric (relative dielectric constant (1 kHz, 25°C): 100 or more) may be used to improve the dielectric constant. Examples of inorganic materials constituting the ferroelectric inorganic oxide particles (B2) and (B3) include, but are not limited to, composite metal oxides, and their composites, solid solutions, sol gel materials, and the like.

The film of the present invention may comprise the "inorganic oxide particles" in an amount of preferably 0.01 to 300 parts by mass, and more preferably 0.1 to 100 parts by mass, per 100 parts by mass of the "vinylidene fluoride-based polymer." An excessively high content of the "inorganic oxide particles" may make it difficult to uniformly disperse the "inorganic oxide particles" in the "vinylidene fluoride-based polymer," and also may decrease electrical insulation properties (withstand voltage). In addition, if the content is 300 parts by mass or more, the film may become brittle and the tensile strength may be insufficient. From this viewpoint, the upper limit of the content is preferably 200 parts by mass, and more preferably 150 parts by mass. If the content is too low, the effect of improving electrical insulation properties is difficult to obtain. From this viewpoint, the lower limit of the content is preferably 0.1 parts by mass, more preferably 0.5 parts by mass, and even more preferably 1 part by mass.

The average primary particle size of the "inorganic oxide particles" is preferably small. In particular, the "inorganic oxide particles" are preferably so-called nanoparticles having an average primary particle size of 1 µm or less. Uniform dispersion of such inorganic oxide nanoparticles allows significant improvement in the electrical insulation properties of the film by the addition of a small amount of the nanoparticles. The average primary particle size is preferably 800 nm or less, more preferably 500 nm or less, and even more preferably 300 nm or less. The lower limit of the average primary particle size is not particularly limited. The average primary particle size is preferably 10 nm or more, more preferably 20 nm or more, and even more preferably 50 nm or more, from the standpoint of difficulty in production, difficulty in uniform dispersion, and cost. The average primary particle size of the "inorganic oxide particles" is calculated using a laser diffraction/scattering particle size distribution analyzer, LA-920 (trade name) (Horiba Ltd.) or an equivalent thereof.

The relative dielectric constant (25°C, 1 kHz) of the "inorganic oxide particles" is preferably 10 or more. When the film is used as a piezoelectric film, in order to enhance the dielectric constant thereof, the relative dielectric constant is preferably 100 or more, and more preferably 300 or more. The upper limit of the relative dielectric constant is not particularly limited, and is generally about 3,000. The relative dielectric constant (ε) (25°C, 1 kHz) of the "inorganic oxide particles" is a value obtained by measuring the capacitance (C) with an LCR meter, and calculating the relative dielectric constant from the capacitance, electrode area (S), and thickness of a sintered body (d), using the formula, C = εε₀×S/d (ε₀: vacuum dielectric constant).

The film of the present invention may comprise other components, such as a compatibility improver, as necessary.

When the film of the present invention comprises the "inorganic oxide particles," it comprises a "compatibility improver."

The "compatibility improver" enhances the compatibility between the "inorganic oxide particles" and the "vinylidene fluoride-based polymer," which allows the "inorganic oxide particles" to be uniformly dispersed in the "vinylidene fluoride-based polymer" while achieving strong bonding between the "inorganic oxide particles" and the "vinylidene fluoride-based polymer" in the film. This suppresses the generation of voids and achieves an increase in the relative dielectric constant.

As the "compatibility improver," a coupling agent, a surfactant, or an epoxy-containing compound is effective.

Examples of the "coupling agent" include organic titanium compounds, organic silane compounds, organic zirconium compounds, organic aluminum compounds, and organic phosphorous compounds.

Examples of the "organic titanium compounds" include coupling agents, such as alkoxy titanium, titanium chelate, and titanium acylate. Of these, preferred examples include alkoxy titanium and titanium chelate because they have excellent compatibility with the "inorganic oxide particles."

Specific examples thereof include tetraisopropyl titanate, titanium isopropoxyoctylene glycolate, diisopropoxy bis(acetylacetonato)titanium, diisopropoxytitanium diisostearate, tetraisopropyl bis(dioctyl phosphite) titanate, isopropyl tri(n-aminoethyl-aminoethyl) titanate, and tetra(2,2-diallyloxymethyl-1-butyl) bis(di-tridecyl) phosphite titanate.

The "organic silane compounds" may be high or low molecular weight compounds. Examples thereof include alkoxysilanes, such as monoalkoxysilane, dialkoxysilane, trialkoxysilane, and tetraalkoxysilane. Vinylsilane, epoxysilane, aminosilane, methacroxy silane, mercaptosilane, and the like can also be suitably used.

When an alkoxysilane is used, further improvement in volume resistivity (improvement in electrical insulation properties), which is an effect of the surface treatment, can be achieved by hydrolysis.

Examples of the "organic zirconium compounds" include alkoxy zirconium and zirconium chelate.

Examples of the organic aluminum compounds include alkoxyaluminum and aluminum chelate.

Examples of the organic phosphorous compounds include phosphorous acid esters, phosphoric acid esters, and phosphoric acid chelates.

The "surfactant" used as a compatibility improver may be a high or low molecular weight surfactant. Examples thereof include nonionic surfactants, anionic surfactants, and cationic surfactants. Of these, high molecular weight surfactants are preferable because they have excellent thermal stability.

Examples of the "nonionic surfactants" include polyether derivatives, polyvinylpyrrolidone derivatives, and alcohol derivatives. Of these, polyether derivatives are preferable because they have excellent compatibility with the "inorganic oxide particles."

Examples of the "anionic surfactants" include polymers containing sulfonic acid, carboxylic acid, and salts thereof. Of these, preferable examples include acrylic acid derivative-based polymers (poly(acrylic acid) derivatives) and methacrylic acid derivative-based polymers (poly(methacrylic acid) derivatives) because they have excellent compatibility with the "vinylidene fluoride-based polymer."

Examples of the "cationic surfactants" include amine compounds, compounds having nitrogen-containing type heterocycles, such as imidazoline; and halogen salts thereof.

The "epoxy-containing compound" used as the "compatibility improver" may be a low or high molecular weight compound. Examples thereof include epoxy compounds and glycidyl compounds. Of these, low molecular weight compounds having one epoxy group are preferable because they have particularly excellent compatibility with the "vinylidene fluoride-based polymer."

Especially from the viewpoint of excellent compatibility with the "vinylidene fluoride-based polymer," preferable examples of the "epoxy-containing compound" include compounds represented by the following formula: 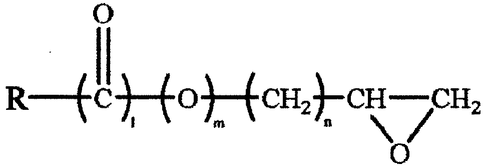 wherein R is a hydrogen atom, a methyl group, a C₂₋₁₀ hydrocarbon group optionally intercalated by oxygen atom(s) or nitrogen atom(s), or an optionally substituted aromatic ring group; 1 represents 0 or 1; m represents 0 or 1; and n represents an integer of 0 to 10.

### Specific examples thereof include

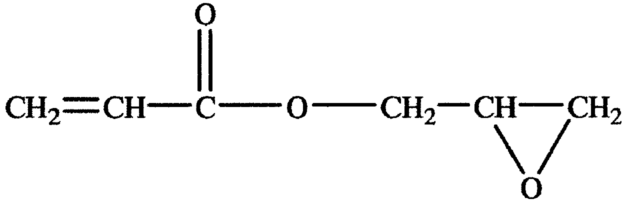

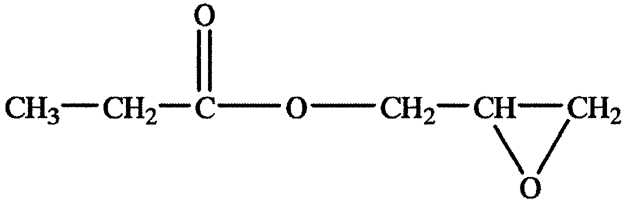

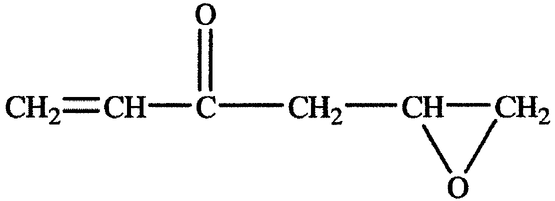

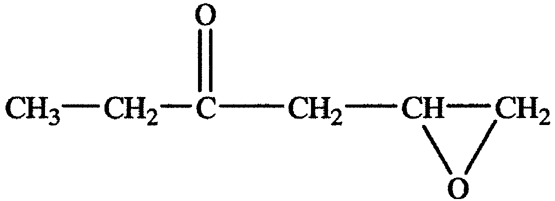

and like compounds containing ketone or ester groups.

The "compatibility improver" may be used in an amount within a range that does not impair the effect of the present invention. Specifically, in order to achieve a uniform dispersion and a high relative dielectric constant of the obtained film, the amount is preferably within the range of 0.01 to 30 parts by mass, more preferably 0.1 to 25 parts by mass, even more preferably 1 to 20 parts by mass, per 100 parts by mass of the "inorganic oxide particles."

The film of the present invention may further comprise other additives to an extent that does not impair the effect of the present invention.

The film of the present invention is preferably such that the curled part caused by heating at 100°C for 60 minutes is within ± 10 mm. Setting the degree of curling within the above range makes it possible to obtain a film that is suitable for use in applications in which precision is required, such as a piezoelectric film, as the film of the present invention.

The curling is measured in the following manner. After the centerline of a film cut to a size having a width of 100 mm and a length of 100 mm is taped onto a metal plate, the film is heated at 100°C for 60 minutes. Both edges of the film lift upward from the metal plate after the heating, and the length by which the film lifts is measured with a caliper.

Examples of the method for setting the degree of curling of the film of the present invention within ±10 mm include a method in which, in the below-described method for producing the film of the present invention, the peel strength between the substrate and the vinylidene fluoride-based polymer film is set to 0.1 N/cm or less, the drying temperature for evaporating the solvent is set to 200°C or less, and the vinylidene fluoride-based polymer solids content in the liquid composition prepared by dissolving or dispersing the vinylidene fluoride-based polymer and optional component(s) in the solvent is set to 5 mass% or more.

### Method for producing a film

The film of the present invention can be produced by, for example, a method comprising:
step A of preparing a liquid composition containing a VdF/TFE copolymer and a solvent;
step B of filtering the liquid composition using a depth-pleated type filter;
step C of casting the filtrate obtained in step B onto a substrate; and
step D of evaporating the solvent from the cast filtrate to form a VdF/TFE copolymer
   film.

When the film of the present invention is a piezoelectric film, the film can be produced by, for example, a method comprising steps A to D above and further comprising, after step D:
step E of subjecting the VdF/TFE copolymer to polarization treatment to obtain a polarized vinylidene fluoride-based polymer film; and
step F of heat-treating the non-polarized or polarized VdF/TFE copolymer film.

### Step A (step of preparing a liquid composition)

In step A, a liquid composition (coating composition) containing a VdF/TFE copolymer and a solvent is prepared. For example, the liquid composition is prepared by dissolving or dispersing a VdF/TFE copolymer in a solvent.

The dissolution temperature in the preparation of the liquid composition is not particularly limited, and a high dissolution temperature is preferable because it promotes dissolution. However, if the dissolution temperature is too high, the obtained film tends to be colored. Thus, the dissolution temperature is preferably not less than room temperature but 80°C or less.

In terms of preventing coloration, preferred examples of solvents include ketone solvents (e.g., methyl ethyl ketone (MEK), methyl isobutyl ketone (MIBK), acetone, diethyl ketone, dipropyl ketone), ester solvents (e.g., ethyl acetate, methyl acetate, propyl acetate, butyl acetate, ethyl lactate), ether solvents (e.g., tetrahydrofuran, methyltetrahydrofuran, dioxane), and amide solvents (e.g., dimethylformamide (DMF), dimethylacetamide, N-methylpyrrolidone (NMP)). These solvents may be used singly or in a combination of two or more. As the solvent, an amide solvent, which is widely used in the dissolution of polyvinylidene fluoride (PVDF), may be used; however, the amount of the amide solvent contained in the solvent is preferably 50% or less.

### Step B (filtration step)

In step B, the liquid composition obtained in step A is filtered using a depth-pleated type filter.

The depth-pleated type filter is generally a filter obtained by creasing a flat membrane (also referred to as nonwoven fabric) formed by, for example, compressing with a compression press after bonding fine fibers through resin bonding or thermal fusion. This depth-pleated type filter has a pleat structure having a large filtration area, thus significantly reducing pressure loss and achieving high particle capture efficiency. In the present invention, a VdF/TFE copolymer film exhibiting high electrical insulation properties and having excellent withstand voltage properties can be produced since impurities, such as dust and undissolved material, can be efficiently removed by filtering the liquid composition obtained in step A using the depth-pleated type filter.

The pore diameter of the depth-pleated type filter is generally within the range of 0.1 to 20 µm, and preferably 0.5 to 15 µm.

A commercially available product may be used as the depth-pleated type filter. Examples include the DIA II Series of Roki Techno Co., Ltd.

In step B, the filtration can be performed at a suitably set pressure. The pressure is generally within the range of 0.01 to 1 MPa, and preferably 0.05 to 0.5 MPa.

### Step C (step of casting (applying) onto substrate)

In step C, the filtrate obtained in step B is cast onto a substrate.

The filtrate may be cast (applied) onto a substrate according to a commonly used method, such as a knife coating method, a cast coating method, a roll coating method, a gravure coating method, a blade coating method, a rod coating method, an air doctor coating method, or a slot die method. Of these, gravure coating methods or slot die methods are preferable from the viewpoint of easy operation, less thickness fluctuation in the obtained film, and excellent productivity. Examples of usable substrates include polyethylene terephthalate (PET) films, and PET films subjected to release treatment with a release agent and steel belts or the like.

### Step D (solvent evaporation step)

In step D, the solvent in the filtrate cast in step C is evaporated to form a VdF/TFE copolymer film.

The evaporation of the solvent can be performed by a commonly used drying method, such as heating.

The drying temperature in the evaporation of the solvent may be suitably determined according to the type of solvent or the like, and is generally within the range of 20°C to 200°C, and preferably 40°C to 170°C.

The drying temperature may be constant or changed. The haze value of the obtained film can be reduced by changing the drying temperature from low temperature (e.g., 40 to 100°C) to high temperature (e.g., 120 to 200°C). This can be achieved by, for example, dividing the drying zone into several zones and allowing the film (or solution cast before film formation) to enter the low-temperature zone and move to the high-temperature zone.

More specifically, for example, the drying zone may be divided into four zones, 50°C, 80°C, 120°C, and 150°C zones, and the film may be moved from the 50°C zone to the 150°C zone continuously.

The drying time for evaporating the solvent is generally within 10 to 600 seconds, and preferably 30 to 300 seconds.

The VdF/TFE copolymer film obtained in step D is preferably unstretched. Moreover, in the production method of the present invention, the non-polarized film is preferably not stretched. That is, the film of the present invention is preferably an unstretched film. The film of the present invention thus obtained has high thickness uniformity. More specifically, the coefficient of variation of thickness of the film of the present invention measured at 10 points per one centimeter square throughout the entire film is preferably ±20% or less of the average film thickness.

### Step E (Polarization treatment step)

The VdF/TFE copolymer film obtained in step D is in the non-polarized state, which is not polarized. Thus, when the "non-polarized vinylidene fluoride-based polymer film" (which hereinafter may be referred to simply as the "non-polarized film") is processed into a piezoelectric film, the polarization treatment of step E and the heat treatment of step F are performed after step D described above. The polarization treatment of step E can be performed by a commonly used method, such as corona discharge treatment.

The polarization treatment of step E is preferably performed by corona discharge.

Either negative corona or positive corona may be used for corona discharge. Negative corona is preferably used because non-polarized resin films are easily polarized.

The corona discharge treatment is not particularly limited. The treatment can be performed, for example, by applying voltage to a non-polarized film using (a) linear electrode(s); or by applying voltage to a non-polarized film using needle-shaped electrodes, as described in JP2011-181748A.

The conditions of the corona discharge treatment may be suitably set based on common knowledge in the art to which the present invention belongs. If the degree of the conditions of the corona discharge treatment is too low, the obtained piezoelectric film may have insufficient piezoelectricity. On the other hand, if the degree of the conditions of the corona discharge treatment is too high, the obtained piezoelectric film may have point-like defects.

For example, when voltage is continuously applied using linear electrodes by a roll-to-roll process, although it varies depending on the distance between the linear electrodes and the non-polarized film, the film thickness, and the like, the direct current electric field is, for example, -15 to -25 kV. The rate of treatment is for example, 10 to 500 cm/min.

As an alternative method other than corona discharge, polarization treatment may be performed, for example, by applying voltage while sandwiching the non-polarized film between plate electrodes. More specifically, the conditions that can be used, for example, when voltage is applied while sandwiching the non-polarized film between plate electrodes, are as follows: the direct current electric field is 0 to 400 MV/m (preferably 50 to 400 MV/m) and the application time is 0.1 seconds to 60 minutes.

The thickness of the non-polarized film used in step E may be determined according to the piezoelectric film to be obtained.

### Step F (Heat treatment step)

Step F is performed after step D or E described above. More specifically, in step F, the non-polarized VdF/TFE copolymer film obtained in step D or the polarized VdF/TFE copolymer film (which hereinafter may be referred to simply as the polarized film) obtained in the polarization treatment of step E is heat-treated. Step F is preferably performed after step E.

The heat treatment of step F can be performed for the polarized film or a portion in which polarization has been completed in step E. More specifically, while the polarization treatment of step E is carried out, the heat treatment of step F may be performed for a portion for which the polarization treatment has been completed.

The method for the heat treatment is not particularly limited, and may be performed, for example, by sandwiching the non-polarized or polarized film between two metal plates and heating the metal plates; heating a roll of the film in a constant-temperature chamber; heating a metal roller and bringing the film into contact with the heated metal roller in the production of the film by a roll-to-roll process; or passing the film through a heated oven by a roll-to-roll process. When the heat treatment is performed, the film may be heat-treated singly, or the film may be stacked on another type of film or a metal foil to form a laminated film and the laminated film may be heat-treated. In particular, when the heat treatment is performed at high temperature, the latter method is preferable because wrinkles are less likely to be formed in the film.

The temperature of the heat treatment may vary depending on the type of film to be heat-treated, and is preferably within the range of (the melting point of the film to be heat-treated - 100)°C to (the melting point of the film to be heat-treated + 40)°C.

More specifically, the temperature of the heat treatment is preferably 80°C or more, more preferably 85°C or more, and even more preferably 90°C or more.

The temperature of the heat treatment is also preferably 170°C or less, more preferably 160°C or less, and even more preferably 140°C or less.

The time for the heat treatment is generally 10 seconds or more, preferably 0.5 minutes or more, more preferably 1 minute or more, and even more preferably 2 minutes or more.

The upper limit of the time for the heat treatment is not limited, and is generally 60 minutes or less.

The conditions of the heat treatment are preferably such that the temperature of the heat treatment is 90°C or more and the time for the heat treatment is 1 minute or more.

In the present specification, the melting point of the film means a maximal value on the heat-of-fusion curve obtained when the temperature is raised at a rate of 10°C/min, using a device for differential scanning calorimetry (DSC).

After the heat treatment, the non-polarized film or polarized film is cooled to a predetermined temperature. The temperature is preferably within the range of 0°C to 60°C, and may be room temperature. The cooling rate may be gradual or rapid, and rapid cooling is preferable from the viewpoint of productivity. Rapid cooling can be performed, for example, by means such as blown air.

### Film roll

The film of the present invention can be stored and shipped, preferably as a roll.

To inhibit wrinkles from occurring in such a roll form, the film of the present invention preferably has an elastic modulus of 500 MPa or more. The elastic modulus can be adjusted by the selection of the film material or the like.

The film roll of the present invention may consist of the film of the present invention, may be in a form in which a protective film or the like is laminated on the film of the present invention and the resulting laminate is wound, or may comprise a core, such as a paper tube, and the film of the present invention wound on the core.

The film roll of the present invention preferably has a width of 50 mm or more and a length of 20 m or more.

The film roll of the present invention can be prepared, for example, by winding the film of the present invention using a feed roller and a takeup roller.

To inhibit deflection of the film, the feed roller is preferably positioned parallel to the takeup roller, as commonly performed.

Also, to inhibit deflection of the film, a film of the present invention having an elastic modulus of 500 MPa or more may be used.

To facilitate slidability of the film of the present invention, rollers having good slidability, more specifically, rollers coated with fluororesin, plated rollers, or rollers to which a release agent is applied are preferably used.

When the thickness of the film is non-uniform, non-uniformity of the thickness of the roll occurs (e.g., so-called high edges of the roll, i.e., the thickness at the end portions of the roll is larger than the center portion in the axial direction of the roll; when the film thickness at both end portions is smaller than that at the center portion, both end portions are narrowed compared to the center portion; or when the thickness gradually changes from one end to the other end, the end on the side having thinner film thickness is narrowed), which may cause wrinkling. This also may cause deflection of a film (bending in a condition in which no tension, except for gravitational tension, is applied) when the film is unwound.

In general, the film edges, which become the ends of a roll, are slit with a slitter to prevent high edges of the roll. However, when non-uniformity of the film thickness is over a wide area from the film edges, it is difficult to prevent high edges and narrowing of a roll only by slitting.

Moreover, the wider (e.g., a width of 100 mm or more) the film and the longer (e.g., 50 m or more) the film, the more likely the high edges, narrowing, and deflection described above are generally to be caused. However, since the film of the present invention has high thickness uniformity, a roll in which the high edges, narrowing, and deflection are suppressed can be obtained by using the film as is or by only slitting the film edges, which become the ends of the roll, with a slitter, even when the film is large in width (e.g., a width of 100 mm or more) and long in length (e.g., 50 m or more).

The edges (film edges) removed by slitting may be collected and recycled as a starting material of the film of the present invention.

The film roll of the present invention has high thickness uniformity, and preferably, the ratio of the thickness of a thicker end to the thickness of the center portion in the axial direction of the roll is within the range of 70 to 130%. Thus, in the film roll of the present invention, the deflection of the film unwound from the roll is suppressed.

The surface roughness Ra of the rollers used for producing the film of the present invention and a roll thereof is preferably 1 µm or less. As used herein, "surface roughness Ra" is the "arithmetic average height" defined in JIS B0601:2001.

In addition, the material of at least the surfaces of the rollers used for producing the film of the present invention and a roll thereof is preferably polytetrafluoroethylene (PTFE), chrome plating, or stainless steel (SUS).

These features inhibit the film from wrinkling.

### Applications

### Piezoelectric panel

The film of the present invention preferably has piezoelectricity and can be used for piezoelectric panels (e.g., touch panels (preferably touch panels that can detect touch pressure)) and the like.

A touch panel comprising the film of the present invention can detect both touch positions and touch pressure, and even when the panel is exposed to extremely high temperatures, its touch pressure detection performance does not decrease easily and its transparency is high.

The film of the present invention can be used for any type of touch panel, such as resistive types and capacitive types.

When the film of the present invention is used for touch panels, it is not necessarily used for detecting both touch positions and touch pressure. The film of the present invention may be used for detecting either touch positions or touch pressure.

A piezoelectric panel comprising the film of the present invention comprises the film of the present invention and electrode(s). The piezoelectric panel preferably comprises, in the following order:
a first electrode (preferably a transparent electrode);
the film of the present invention (preferably a transparent piezoelectric film); and
a second electrode (preferably a transparent electrode).

The first electrode is directly or indirectly disposed on one principal surface of the film of the present invention, and the second electrode is directly or indirectly disposed on the other principal surface of the film of the present invention.

Examples of the electrodes include ITO (indium tin oxide) electrodes, tin oxide electrodes, metal nanowires, metal nanoparticles, organic conductive resins, and the like.

When a piezoelectric panel (e.g., a touch panel (preferably a touch panel that can detect touch pressure)) comprising the film of the present invention is pressed with a finger or the like, an electrical signal in response to the temporal change in distortion of the film of the present invention can be obtained; therefore, use of the piezoelectric panel makes it possible to determine the presence or absence, speed, or degree (intensity) of pressing, or changes thereof, or combinations thereof. The degree of pressing (i.e., static pressure) can be determined using an integral value of the electrical signal.

In a piezoelectric panel comprising the film of the present invention, one or more (preferably two) films of the present invention may be used.

When two or more (preferably two) films of the present invention are used, the two or more films may be bonded to each other with an adhesive sheet. The adhesive sheet is not particularly limited insofar as it can bond the films of the present invention together. The adhesive sheet may be formed of one or more layers. Specifically, when the adhesive sheet is formed of one layer, the adhesive sheet is consisting of an adhesive layer, and when the adhesive sheet is consisting of two or more layers, both outer layers of the sheet are adhesive layers. When the adhesive sheet is consisting of three or more layers, the adhesive sheet may comprise a substrate layer as an inner layer.

The adhesive layer(s) in the adhesive sheet may be layer(s) containing an acrylic adhesive as an adhesive.

The substrate layer in the adhesive sheet may be any layer insofar as it is a transparent film. The substrate layer is preferably, for example, a film of polyimide, polyethylene terephthalate, polybutylene terephthalate, polycarbonate, polyparaphenylene sulfide, or polyamideimide.

For example, a piezoelectric panel (e.g., a touch panel (preferably a touch panel that can detect touch pressure)) comprising the film of the present invention preferably comprises, in the following order:
a first electrode;
a first film of the present invention;
an adhesive sheet;
a second film of the present invention; and
a second electrode.
The first electrode is disposed on the outer surface of the first film of the present invention, and the second electrode is disposed on the outer surface of the second film of the present invention.

The film of the present invention can have pyroelectricity; however, in the piezoelectric panel (e.g., a touch panel (preferably a touch panel that can detect touch pressure)), electrical signals due to pyroelectricity are reduced, and electrical signals due to piezoelectricity can be selectively obtained when the first film of the present invention and the second film of the present invention are disposed so that their surfaces on which electric charges of the same polarity (for example, a positive charge and a positive charge) are generated by an increase in temperature are respectively positioned on the outer sides thereof, and a potential difference between the two surfaces is obtained as an electrical signal by the first electrode and the second electrode.

A touch panel comprising the film of the present invention can be used for input devices and touch sensor devices. An input device comprising the touch panel (i.e., an input device comprising the piezoelectric film of the present invention) is capable of input based on touch positions, touch pressure, or both (e.g., input based on the degree (intensity) of pressing, such as writing pressure). An input device and a touch sensor device both comprising the touch panel can have a position detector and a pressure detector.

The input device can be used for electronic devices (e.g., cellular phones (for example, smartphones), personal digital assistants (PDAs), tablet PCs, ATMs, automatic ticket vending machines, digitizers, touchpads, car navigation systems, and touch panel displays (touch panel monitors) of FA (factory automation) devices and the like). An electronic device comprising the input device allows for operations and actions based on touch positions, touch pressure, or both (e.g., operations, such as changing the thickness of lines displayed on a screen according to writing pressure in a painting software).

The touch sensor device can be used for electronic devices (e.g., collision sensors and robotic vacuum cleaners).

The electronic devices may comprise the touch input device of the present invention or the touch sensor device of the present invention, or may consist of the touch input device of the present invention or the touch sensor device of the present invention.

### Electrowetting device

The film of the present invention has electrowetting properties and can be used for electrowetting devices. As used herein, the "electrowetting" means changing wettability on the film surface between hydrophobicity (water repellency) and hydrophilicity using an electric field. "Electrowetting devices" refer to devices that use "electrowetting."

The film of the present invention can be suitably used for electrowetting devices, such as optical elements, display devices (displays), variable-focus lenses, optical modulation devices, optical pickup devices, optical recording and reproducing devices, image-developing devices, devices for droplet manipulation, and analytical instruments (e.g., instruments for chemical, biochemical, and biological analyses that require a small amount of a conductive liquid to be moved for analyzing a sample).

The film of the present invention has a high relative dielectric constant and a low dielectric dissipation factor. This makes it possible to drive a conductive liquid at a low voltage.

### Film capacitor

Since the film of the present invention has a high relative dielectric constant and a low dielectric dissipation factor, it can also be suitably used as a film for film capacitors. The film of the present invention is advantageous as a film for film capacitors also in that high dielectric properties, which are a feature of vinylidene fluoride-based resin, are not impaired even if voltage is applied for a long period of time.

A film capacitor using the film of the present invention can be produced, for example, by obtaining a dielectric film in which a metal membrane of aluminum, zinc, or the like is formed on (a) principal surface(s) of the film of the present invention and stacking a plurality of dielectric film layers. The metal membrane can be formed by vapor deposition or the like.

### Transparent cover film

Since the film of the present invention comprises a vinylidene-based resin with excellent weather resistance and has very high transparency, it can also be used as a transparent cover film. In this case, for example, laminating a polycarbonate or PET film on the film of the present invention can impart weather resistance thereto.

The film of the present invention is flexible and can thus be suitably used for various applications.

### Examples

Examples are given below to illustrate the present invention in more detail; however, the present invention is not limited to these Examples.

Hereinafter, the molar ratio of repeating units derived from tetrafluoroethylene/repeating units derived from vinylidene fluoride in a vinylidene fluoride/tetrafluoroethylene copolymer may be referred to as "TFE/VDF."

### Example 1 (Example as a piezoelectric film)

(1) A vinylidene fluoride/tetrafluoroethylene copolymer (TFE/VDF = 20/80) was dissolved in methyl ethyl ketone (MEK) to prepare a coating composition having a solids content of 25 wt%, and the coating composition was then filtered with a depth-pleated type filter having a pore diameter of 3 µm (DIA II Series of Roki Techno Co., Ltd.) to obtain a filtrate.
(2) Subsequently, the filtrate was applied to a PET film with a die coater and further dried to prepare a vinylidene fluoride/tetrafluoroethylene copolymer film (the thickness of the copolymer film: 25 µm) on the PET film. In this process, the drying was performed at a peripheral speed of 8 m/min in a drying oven in which the drying temperatures in four zones (2 m per zone) were respectively set at 50°C, 80°C, 120°C, and 150°C.
(3) Next, the copolymer film was peeled off from the PET film, vertically sandwiched between metal electrodes, and polarized by applying DC voltage at 300 kV/cm at room temperature for 5 minutes.
(4) Thereafter, the polarized copolymer film was subjected to heat treatment (annealing treatment) in a hot-air dryer at 90°C for 5 minutes to obtain the piezoelectric film of Example 1.

### Comparative Example 1 (Comparative Example as a piezoelectric film)

The piezoelectric film of Comparative Example 1 was obtained in the same manner as in Example 1, except that the coating composition was not filtered with a filter.

### Method for measuring the 99% voltage failure resistance value in a Weibull plot

First, the 99% voltage failure resistance value (V/µm) of each of the piezoelectric films of Example 1 and Comparative Example 1 in a Weibull plot was measured (calculated) as follws. More specifically, it was measured according to the following procedures (1) to (5).
(1) Each film is individually set on a copper plate so that no wrinkles are present.
(2) A spherical electrode is set so that it is in contact with each film.
(3) The limit current value is set to 1 mA and voltage is increased at 100 V/s.
(4) Voltage at which short-circuiting occurs and the limit current value is exceeded is regarded as withstand voltage.
(5) The withstand voltage at 54 points in each film having a size of 20 cm × 10 cm is measured, and the withstand voltage values are plotted in the Weibull distribution. The value at which the probability of failure is 1% is defined as the 99% voltage failure resistance value.

### Method for measuring the number of defects per m²

Next, the number of defects (the number of short-circuit breakdown sites) of each of the piezoelectric films of Example 1 and Comparative Example 1 per m² (the number of defects/m²) was measured (calculated) as follows. More specifically, it was measured according to the following procedures (1) to (3).
(1) Each film having a size of 20 cm × 10 cm is subjected to polarization treatment by the above-mentioned process of the Example.
(2) After (1), the number of breakdowns is visually counted.
(3) The above operations are performed using 5 samples for each film and the number of defects is converted into the number of defects per m².

### Evaluation of appearance

Subsequently, the appearance of each of the piezoelectric films of Example 1 and Comparative Example 1 was evaluated. More specifically, it was evaluated according to the following procedures (1) and (2).
(1) Each piezoelectric film was cut to a size of 100 mm in width × 100 mm in length.
(2) Each piezoelectric film cut in (1) was visually evaluated.

The following table shows the results.

**Table 1**

| | 99% voltage failure resistance value in a Weibull plot (V/µm) | The number of defects per m² (the number of defects/m²) | Appearance |
|---|---|---|---|
| Example 1 | 560 | 0.2 | No black spots |
| Comparative Example 1 | 280 | 62 | Many black spots |

The above results clearly show that when a piezoelectric film is produced without using a depth-pleated type filter, the obtained film has many black spots (poor appearance) because it has low withstand voltage and many defects, thus causing short-circuit breakdowns in many sites when polarized.

### Example 2 (Example as a film for a film capacitor)

(1) 90 parts by mass of a vinylidene fluoride/tetrafluoroethylene copolymer (TFE/VDF=7/93) was mixed with 10 parts by mass of carboxybutyl cellulose.
(2) Subsequently, the copolymer and carboxybutyl cellulose were dissolved in a mixed solvent of N-methylpyrrolidone (NMP) and methyl ethyl ketone (MEK) (NMP:MEK = 3:7 (mass ratio)) so that the solids content was 20 wt%, thereby preparing a coating composition.
(3) Next, the coating composition was filtered with a depth-pleated type filter having a pore diameter of 3 µm (DIA II Series of Roki Techno Co., Ltd.) to obtain a filtrate.
(4) Thereafter, the filtrate was applied to a PET film with a die coater and further dried, thereby preparing a film for a film capacitor (the thickness of the film: 3 µm) comprising the vinylidene fluoride/tetrafluoroethylene copolymer on the PET film. In this process, the drying was performed at a peripheral speed of 8 m/min in a drying oven in which the drying temperatures in four zones (2 m per zone) were respectively set at 170°C, 140°C, 140°C, and 120°C.
(5) Then, after the film for a film capacitor was peeled off from the PET film, aluminum was vapor-deposited on one principal surface of the film for a film capacitor so that the resistance was 4 Ω.
(6) After that, the film for a film capacitor on which aluminum was vapor-deposited was cut into four pieces having a width of 30 mm and a length of 80 mm, and the four pieces were laminated (stacked) to form a laminate. The laminate was then sandwiched between two glass plates, and leads were extended fron the end surfaces on both sides to prepare a stamp-type film capacitor.

### Comparative Example 2 (Comparative Example as a film for a film capacitor)

The film for a film capacitor of Comparative Example 2 and a film capacitor comprising the film were prepared in the same manner as in Example 2, except that the coating composition was not filtered with a filter.

### Method for measuring the 99% voltage failure resistance value in a Weibull plot

First, the 99% voltage failure resistance value (V/µm) of each of the films for a film capacitor of Example 2 and Comparative Example 2 in a Weibull plot was measured (calculated) in the same manner as in the measurement (calculation) method for the piezoelectric film of Example 1.

### Method for measuring the withstand voltage of a capacitor

Next, the withstand voltage until short-circuiting was measured by applying voltage to each of the film capacitors obtained in Example 2 and Comparative Example 2 while increasing the voltage at a speed of 100 V per minute.

The following table shows the results.

**Table 2**

| | 99% voltage failure resistance value in a Weibull plot (V/µm) | Withstand voltage of a film capacitor (V) |
|---|---|---|
| Example 2 | 520 | 1300 |
| Comparative Example 2 | 220 | 250 |

The above results clearly show that when a film for a capacitor and a film capacitor comprising the film are prepared without using a depth-pleated type filter, the film has a large number of defects, resulting in a significantly low withstand voltage of the film capacitor.

### Industrial Applicability

The film of the present invention can be used for touch panels, film capacitors, and the like.

## Claims

1. A vinylidene fluoride/tetrafluoroethylene (VdF/TFE) copolymer film in which the 99% voltage failure resistance value in a Weibull plot is 300 V/µm or more.

2. The film of claim 1, wherein the copolymer film is a piezoelectric film.

3. The film of claim 1, wherein the copolymer film is a film for a film capacitor.

4. A method for producing the film of any of claims 1-3, comprising the steps of
(A) preparing a liquid composition containing a VdF/TFE copolymer and a solvent;
(B) filtering the liquid composition using a depth-pleated type filter;
(C) casting the filtrate obtained in step (B) onto a substrate; and
(D) evaporating the solvent from the cast filtrate to form a VdF/TFE copolymer film.

5. A method for producing the film of claim 1 or 2, comprising the steps of
(A) preparing a liquid composition containing a VdF/TFE copolymer and a solvent;
(B) filtering the liquid composition using a depth-pleated type filter;
(C) casting the filtrate obtained in step (B) onto a substrate;
(D) evaporating the solvent from the cast filtrate to form a non-polarized VdF/TFE copolymer film;
(E) subjecting the film to polarization treatment to obtain a polarized VdF/TFE copolymer film; and
(F) heat-treating the non-polarized or polarized VdF/TFE copolymer film.

## Patentansprüche

1. Vinylidenfluorid-/Tetrafluorethylen (VdF/TFE)-Copolymerfolie, in welcher der 99%-ige Widerstandswert gegen Spannungsausfall in einem Weibull-Plot 300 V/µm oder mehr beträgt.

2. Folie gemäß Anspruch 1, worin die Copolymerfolie eine piezoelektrische Folie ist.

3. Folie gemäß Anspruch 1, worin die Copolymerfolie eine Folie für einen Folienkondensator ist.

4. Verfahren zur Herstellung der Folie gemäß mindestens einem der Ansprüche 1-3, umfassend die Schritte
(A) Herstellen einer flüssigen Zusammensetzung, die ein VdF/TFE-Copolymer und ein Lösungsmittel enthält;
(B) Filtrieren der flüssigen Zusammensetzung unter Verwendung eines Tiefenfaltenfilters;
(C) Gießen des in Schritt (B) erhaltenen Filtrats auf ein Substrat;
(D) Verdampfen des Lösungsmittels vom Gussfiltrat zur Bildung einer VdF/TFE-Copolymerfolie.

5. Verfahren zur Herstellung einer Folie gemäß Anspruch 1 oder 2, umfassend die Schritte
(A) Herstellen einer flüssigen Zusammensetzung, die ein VdF/TFE-Copolymer und ein Lösungsmittel enthält;
(B) Filtrieren der flüssigen Zusammensetzung unter Verwendung eines Tiefenfaltenfilters;
(C) Gießen des in Schritt (B) erhaltenen Filtrats auf ein Substrat;
(D) Verdampfen des Lösungsmittels vom Gussfiltrat zur Bildung einer nicht-polarisierten VdF/TFE-Copolymerfolie;
(E) Polarisierungsbehandeln der Folie, so dass eine polarisierte VdF/TFE-Copolymerfolie erhalten wird; und
(F) Wärmebehandeln der nicht-polarisierten oder polarisierten VdF/TFE-Copolymerfolie.

## Revendications

1. Film de copolymère de fluorure de vinylidène/tétrafluoroéthylène (VdF/TFE) dans lequel la valeur de résistance à une défaillance de tension de 99 % dans un diagramme de Weibull est égale ou supérieure à 300 V/µm.

2. Film selon la revendication 1, dans lequel le film de copolymère est un film piézoélectrique.

3. Film selon la revendication 1, dans lequel le film de copolymère est un film pour un condensateur à film.

4. Procédé de fabrication du film selon l'une quelconque des revendications 1 à 3, comprenant les étapes de :
(A) préparation d'une composition liquide contenant un copolymère VdF/TFE et un solvant ;
(B) filtrage de la composition liquide en utilisant un filtre de type plissé en profondeur ;
(C) coulage du filtrat obtenu à l'étape (B) sur un substrat ; et
(D) évaporation du solvant du filtrat coulé pour former un film de copolymère VdF/TFE.

5. Procédé de fabrication du film de la revendication 1 ou 2, comprenant les étapes de :
(A) préparation d'une composition liquide contenant un copolymère VdF/TFE et un solvant ;
(B) filtrage de la composition liquide en utilisant un filtre de type plissé en profondeur ;
(C) coulage du filtrat obtenu à l'étape (B) sur un substrat ;
(D) évaporation du solvant du filtrat coulé pour former un film de copolymère VdF/TFE non-polarisé ;
(E) soumission du film à un traitement de polarisation pour obtenir un film de copolymère VdF/TFE polarisé ; et
(F) traitement thermique du film de copolymère VdF/TFE non-polarisé ou polarisé.
